# EUROPÄISCHE PATENTSCHRIFT

(11) **EP 3 468 933 B1**
(45) Veröffentlichungstag und Bekanntmachung des Hinweises auf die Patenterteilung: **16.09.2020**
(21) Anmeldenummer: 17735402.4
(22) Anmeldetag: 14.06.2017
(51) Int. Cl.: C03C 27/00, H01L 51/52, H01L 21/56, H01L 21/50

(54) **VERFAHREN UND VORRICHTUNG ZUR VERKAPSELUNG VON BAUTEILEN**
METHOD AND DEVICE FOR ENCAPSULATING COMPONENTS
PROCÉDÉ ET DISPOSITIF PERMETTANT L'ENCAPSULATION DE COMPOSANTS

(30) Priorität: 14.06.2016 DE 102016110868
(43) Veröffentlichungstag der Anmeldung: 17.04.2019
(73) Patentinhaber: Gross, Leander Kilian, 01465 Langebrück (DE); Gross, Mascha Elly, 01465 Langebrück (DE)
(72) Erfinder: GROSS, Harald, 01465 Langebrück (DE)
(74) Vertreter: Lippert Stachow Patentanwälte Rechtsanwälte Partnerschaft mbB
(86) Internationale Anmeldenummer: PCT/EP2017/064615
(87) Internationale Veröffentlichungsnummer: WO 2017/216261

(56) Entgegenhaltungen:
- DE-A1-102005 044 523
- DE-A1-102012 107 468
- US-A1- 2003 066 311
- US-A1- 2004 207 314
- US-B1- 8 202 407

## Beschreibung

Die Erfindung betrifft ein Verfahren und eine Vorrichtung zur hermetischen Verkapselung von Bauteilen. Mit Bauteilen sind beispielsweise Sensoren, Displays, Photovoltaik-Module oder Mikroelektronik gemeint, welche vor Umwelteinflüssen wie Wasserdampf, Sauerstoff oder auch reaktiven Gasen geschützt werden müssen.

In vielen Fällen wie z.B. bei OLED-Displays wird das Bauteil durch eine Glasscheibe gleicher Fläche abgedeckt und am Rand der Fläche mit dem Bauteil verklebt. Der dabei eingesetzte Klebstoff kann ein Epoxidharz sein, welches mittels UV-Licht zur Polymerisation aktiviert wird. Das Epoxidharz hat zwar eine geringe, aber nicht vernachlässigbare Durchlässigkeit für Wasserdampf oder Sauerstoff im Gegensatz zu einer Glasscheibe, sodass im Fall von OLED-Displays zusätzlich ein Getter in die Verkapselung eingebracht werden muss, um das Bauteil auch mehrere Jahre lang vor Sauerstoff oder Luftfeuchtigkeit zu schützen.

Bei Drehraten-Sensoren aus Silizium für Automobile oder Flugzeuge ist i.a. ein gutes Vakuum Voraussetzung für eine hohe Güte einer Schwingung kleiner Massen auf der Oberfläche des Bauteils und der dadurch erzielbaren Messgenauigkeit von Positionsänderungen. Hierbei sind Epoxidharze unter Verwendung von Getter nicht ausreichend, sodass beispielsweise der organische Klebstoff durch ein Glaslot ersetzt wird. Glaslot ist ein Glas mit besonders niedriger Erweichungstemperatur von z.B. 400°C aufgrund des Zusatzes von Bor, Bleioxid und auch anderen Stoffen. Zur Verkapselung wird zuerst auf den Rand einer Glasscheibe per Siebdruck eine Paste mit Glaslot aufgebracht und anschließend durch Trocknung bei Temperaturen von z.B. 300°C die organischen Binder und Lösungsmittel der Paste entfernt. Danach wird die Glasscheibe in einer Vakuumkammer auf die Oberfläche mit der schwingenden Masse des Bauteils aufgepresst und das dazwischen befindliche Glaslot mittels Infrarotstrahler zum Schmelzen gebracht. Nach der Abkühlung im Vakuum bleibt der Raum zwischen Bauteil und Glasscheibe und folglich auch die unmittelbare Umgebung der schwingenden Masse evakuiert, auch nach Belüftung des Vakuumofens. Nachteil dieses Verfahrens ist, dass sowohl das Bauteil, als auch die Glasscheibe dieselben Temperaturen erreichen wie das Glaslot. Darüber hinaus beträgt die Erwärmungs- und Abkühlzeit typischerweise mehrere Minuten und ist somit hinderlich für eine Produktion mit hohem Durchsatz.

Aufgrund der hohen Schmelztemperaturen ist Glaslot zur Verkapselung von OLED-Displays in konventionellen Öfen nicht geeignet, da die Organik Temperaturen über ungefähr 100°C nicht toleriert. Für viele Arten von Bauteilen besteht eine Temperaturbeschränkung deutlich unterhalb der Schmelztemperatur von Glasloten, insbesondere wenn diese organische Materialien enthalten.

In der Patentanmeldung US2004207314A1 "Glass Package that is Hermetically Sealed with a Frit and Method of Fabrication" wird ein Verfahren beschrieben, welches durch gepulstes Laserlicht kurzzeitig das Glaslot bis zum Schmelzpunkt erwärmt. Hierbei erfolgen die Erwärmung sowie die Abkühlung des Substrats so rasch, dass sich weder das Bauteil noch die Glasscheibe zur Verkapselung signifikant erwärmen. Nachteil dieses Verfahrens ist die sequentielle Erwärmung des Glaslots, d.h. der i.a. punktförmige Laserstrahl führt zu einer punktuellen Erwärmung des Glaslots. Für eine vollständige Verkapselung muss der Laserstrahl über die gesamte Oberfläche des Glaslots gerastert werden. Es hat sich dabei herausgestellt, dass eine bestimmte Rastergeschwindigkeit bei entsprechender Laserleistung eingehalten werden muss, um thermomechanische Spannungen unterhalb der Bruchgrenze der verwendeten Materialien und Bauteilen zu halten. Dies beschränkt den Durchsatz in der Produktion erheblich, insbesondere wenn es sich um große Bauteile wie Photovoltaik-Module oder hohe Stückzahlen wie bei Drehraten-Sensoren handelt.

Alternativ zu Lasern werden in der Patentanmeldung Infrarotlampen erwähnt. Mit diesen Lampen können nur Lichtleistungen pro Fläche erzielt werden, die mehrere Größenordnungen unterhalb von Lasern bei z.B. gleicher Wellenlänge liegen. Damit steigt die zur Schmelzung des Glaslots erforderliche Expositionszeit entsprechend auf mindestens eine bis mehrere Sekunden an. Folglich muss aufgrund der Wärmeleitung ein Abstand von mehreren Millimetern bis Zentimetern zwischen Glaslot und dem temperatursensiblen Bereich des Bauteils eingehalten werden, um bei letzterem eine anwendungsabhängige maximale Temperatur nicht zu überschreiten. Damit scheiden Infrarotlampen für Anwendungen aus, bei denen eine Kombination von großer Temperaturempfindlichkeit wie bei OLEDs und von guter Flächenausnutzung bzw. von hoher Produktionsausbeute vorgegeben ist.

Ziel der Erfindung ist ein Verfahren zur Erwärmung eines Glaslots oder auch anderer lichtabsorbierender anorganischer Mittel zur hermetischen Verkapselung eines Bauteils mit Hilfe einer Glasplatte oder auch anderer lichttransparenter anorganischer Materialien. Dabei sollen temperaturempfindliche Bereiche des Bauteils nicht wesentlich über die Raumtemperatur erwärmt werden gemäß der Verkapselung mit einem Laser in der zuvor erwähnten Patentanmeldung US2004207314A1. Im Gegensatz zur Verkapselung mit einem Laser soll der Durchsatz in der Produktion ein Vielfaches betragen.

Mit Licht sind generell elektromagnetische Wellen in einem Spektralbereich gemeint, welche vom menschlichen Auge erfasst werden können, also ein Wellenlängenbereich von ca. 380nm bis 780nm. Dieser Spektralbereich ist auch für lichtabsorbierende, lichtreflektierende und transparente Stoffe gemeint. In manchen Fällen kann die Erweiterung dieses Spektralbereichs auf direkt daran angrenzende elektromagnetische Wellenlängenbereiche sinnvoll sein. Beispielsweise liegt das Emissionsmaximum von Halogenlampen bei ungefähr 920nm, wobei auch geringe UV-Anteile im Emissionsspektrum enthalten sind, also Wellenlängen unterhalb von 380nm. Silikat-Gläser sind i.a. über den für das menschliche Auge sichtbaren Bereich hinaus transparent.

Zu lichttransparenten anorganischen Materialien zählen auch Saphir, also eine Kristallform von Aluminiumoxid und Keramiken wie Aluminiumnitrid oder Aluminiumoxynitrid. Mit lichtabsorbierenden Mitteln sind neben einer ganzen Reihe von Glasloten auch Lote aus Metalllegierungen oder reine Metallschichten gemeint. Beispielsweise kann eine dünne Schicht von 200 Nanometern aus Aluminium oder Gold auf einer Glasplatte aufgebracht werden, welche bei der Erwärmung auf 580°C bzw. 370°C mit einem Bauteil aus Silizium eine eutektische Verbindung eingeht. Die angegebenen Prozesstemperaturen liegen dabei unter den Schmelzpunkten von Aluminium oder Gold.

Das zuvor beschriebene Ziel der Erfindung wird durch die Verwendung von mindestens einer Gasentladungslampe erreicht, welche Erwärmungszeiten von ungefähr 0,1 Millisekunden (Betrieb als Blitzlampe) bis ungefähr 1000 Millisekunden (Betrieb mit kontinuierlicher Leistung) bei hohen Lichtintensitäten ermöglicht. Beispielsweise können mehrere axiale Blitzlampen mit einer Lichtbogenlänge von beispielsweise zwei Metern in einer Ebene parallel zueinander angeordnet werden, um großflächige OLED-Fernseher oder Photovoltaik-Module einzeln zu verkapseln. Es kann auch eine Vielzahl von Drehraten-Sensoren in einer Ebene angeordnet werden die parallel zu einem Feld von Blitzlampen ausgerichtet ist, um alle Sensoren gleichzeitig zu verkapseln. Damit ist ein Vielfaches an Durchsatz in der Produktion im Vergleich zur Verkapselung mit Lasern oder auch in konventionellen Öfen möglich.

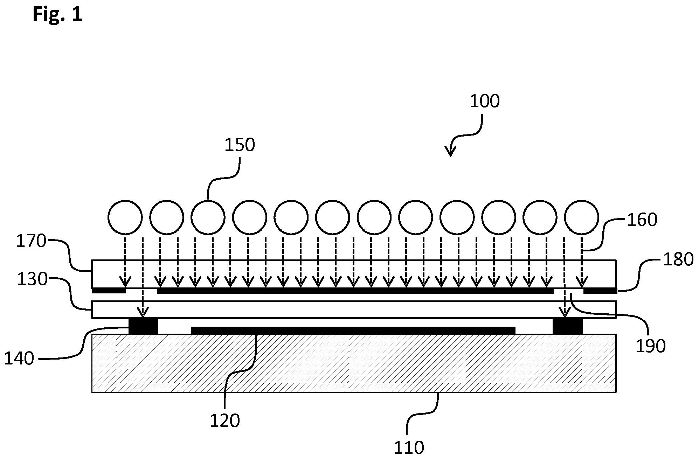

Figur 1 zeigt einen nicht maßstäblichen Querschnitt einer Anordnung (100) gemäß der Vorrichtung der Erfindung, welche die Belichtung des gesamten Bauteils (110) verhindert bzw. das von den Gasentladungslampen (150) emittierte Licht (160) auf Bereiche mit einem lichtabsorbierenden anorganischen Mittel (140) begrenzt. Das lichtabsorbierende Mittel (140), z.B. ein 50µm dickes Glaslot wird in einem vorhergehenden, nicht gezeigten Prozessschritt auf das für Licht transparente anorganische Material (130), z.B. eine Glasscheibe zur Verkapselung aufgebracht. Die Abschattung des Bauteils (110) erfolgt durch eine transparente Maske (170) aus einem Trägermaterial, z.B. Quarzglas. Die Maske (170) ist mit einer intransparenten und lichtreflektierenden Schicht (180) ausgestattet, die nur an wenigen Stellen (190) unterbrochen bzw. geöffnet ist, sodass das emittierte Licht (160) an diesen Stellen auf das lichtabsorbierende Mittel (140) zu dessen Erwärmung fallen kann. Somit wird der temperatursensible Bereich (120) des Bauteils, z.B. ein OLED-Display nicht belichtet bzw. nur unwesentlich erwärmt. Bei großflächigen Bauteilen wie Photovoltaik-Modulen können Gasentladungslampen (150), die weit von den Öffnungen (190) entfernt sind, eingespart werden. Idealerweise wird die Maske (170) zum Anpressen des Materials (130) auf das Bauteil (110) während des Verkapselungsprozesses verwendet. Dabei liegt das Bauteil (110) auf einer nicht skizzierten Unterlage. In Experimenten hat sich das Anpressen als vorteilhaft für eine hermetische Verkapselung erwiesen, wenn die durch die Gewichtskraft des Materials (130) auf das Bauteil (110) hervorgerufenen Anpresskraft nicht ausreicht. Dies gilt insbesondere bei kleinen Bauteilen wie Sensoren. Alternativ zur lichtreflektierenden Schicht (180) der Maske (170) kann auch eine lichtabsorbierende Schicht eingesetzt werden. Eine lichtabsorbierende Schicht kann zwar die Lichteffizienz der Gasentladungslampen erhöhen, allerdings muss dann die Maske (170) wesentlich besser gekühlt werden, insbesondere bei hohem Durchsatz in der Produktion.

### Bezugszeichenliste

- 100:: Vorrichtung gemäß der Erfindung
- 110:: Bauteil
- 120:: Temperaturempfindlicher Bereich des Bauteils
- 130:: Anorganisches lichttransparentes Material
- 140:: Lichtabsorbierendes anorganisches Mittel
- 150:: Gasentladungslampen
- 160:: Von den Gasentladungslampen emittiertes Licht
- 170:: Maske
- 180:: Lichtreflektierende Schicht auf Maske
- 190:: Öffnungen in der lichtreflektierenden Schicht der Maske

## Patentansprüche

1. Verfahren zur Verkapselung eines Bauteils unter Verwendung eines anorganischen lichttransparenten Materials und unter Verwendung eines anorganischen lichtabsorbierenden Mittels **dadurch gekennzeichnet, dass** das lichtabsorbierende Mittel mit Hilfe von mindestens einer Gasentladungslampe für eine Dauer von weniger als eine Sekunde erwärmt wird zur hermetischen Verbindung des Bauteils mit dem lichttransparenten Material.

2. Verfahren gemäß Anspruch 1, wobei das anorganische lichttransparente Material ein Silikat-Glas ist.

3. Verfahren gemäß Anspruch 1, wobei das anorganische lichtabsorbierende Mittel ein Glaslot, ein Lot aus einer Metalllegierung oder eine Metallschicht ist.

4. Verfahren gemäß Anspruch 1, wobei das Bauteil mindestens einen Sensor, ein Display, einen Halbleiter für Photovoltaik, Mikroelektronik enthält,

5. Verfahren gemäß Anspruch 1, wobei die mittlere Temperatur des Bauteils durch den Verkapselungsprozess um weniger als 80 Grad Celsius ansteigt.

6. Verfahren gemäß Anspruch 1, wobei die Gasentladungslampe als Blitzlampe oder mit kontinuierlicher Leistung betrieben wird.

7. Vorrichtung (100), ausgebildet zur Verkapselung eines Bauteils (110) nach einem Verfahren der vorstehenden Ansprüche unter Verwendung eines anorganischen lichttransparenten Materials (130), unter Verwendung eines anorganischen lichtabsorbierenden Mittels (140) **dadurch gekennzeichnet, dass** mindestens eine Gasentladungslampe (150) zur Erwärmung des Mittels für eine hermetische Verbindung des Bauteils mit dem lichttransparenten Material verwendet wird und dass zwischen dem lichttransparenten Material und mindestens der einen Gasentladungslampe eine Maske (170) eingefügt ist zur Begrenzung des Lichteinfalls (160) auf mit dem lichtabsorbierenden Mittel zu verbindenden Bereiche des Bauteils.

8. Vorrichtung (100) zur Verkapselung eines Bauteils (110) nach Anspruch 7, **dadurch gekennzeichnete, dass** die Gasentladungslampe (150) für den Blitzbetrieb und/oder für den kontinuierlichen Betrieb konfiguriert ist.

9. Vorrichtung gemäß Anspruch 7 oder 8, wobei die Maske aus einem für Licht der Gasentladungslampe transparenten Trägermaterial besteht worauf eine lichtreflektierende Schicht (180) mit Öffnungen (190) aufgebracht ist.

10. Vorrichtung gemäß Anspruch 9, wobei die Maske (170) zum Anpressen des lichttransparenten Materials (130) auf das Bauteil (110) während des Verkapselungsprozesses verwendet wird.

## Claims

1. Method for encapsulating a component using an inorganic light-transparent material and using an inorganic light-absorbing means, **characterized in that** the light-absorbing means is heated for a duration of less than one second with the aid of at least one gas discharge lamp for the hermetic bonding of the component to the light-transparent material.

2. Method according to Claim 1, wherein the inorganic light-transparent material is a silicate glass.

3. Method according to Claim 1, wherein the inorganic light-absorbing means is a glass solder, a solder made of a metal alloy, or a metal layer.

4. Method according to Claim 1, wherein the component contains at least one sensor, one display screen, or one semiconductor for photovoltaics or microelectronics.

5. Method according to Claim 1, wherein the mean temperature of the component rises by less than 80°C due to the encapsulation process.

6. Method according to Claim 1, wherein the gas discharge lamp is operated as a flash lamp or using continuous power.

7. Device (100) designed for encapsulating a component (110) according to a method of the preceding claims using an inorganic light-transparent material (130), using an inorganic light-absorbing means (140), **characterized in that** at least one gas discharge lamp (150) for heating the means for a hermetic bond of the component to the light-transparent material is used, and **in that** a mask (170) is incorporated between the light-transparent material and at least the one gas discharge lamp to limit the light incidence (160) on regions of the component to be bonded with the light-absorbing means.

8. Device (100) for encapsulating a component (110) according to Claim 7, **characterized in that** the gas discharge lamp (150) is configured for flash operation and/or for continuous operation.

9. Device according to Claim 7 or 8, wherein the mask consists of a carrier material transparent to light of the gas discharge lamp, on which a light-reflecting layer (180) having openings (190) is applied.

10. Device according to Claim 9, wherein the mask (170) is used to press the light-transparent material (130) onto the component (110) during the encapsulation process.

## Revendications

1. Procédé pour encapsuler un composant en utilisant un matériau anorganique transparent à la lumière et en utilisant un moyen anorganique absorbant la lumière, **caractérisé en ce que** le moyen absorbant la lumière est chauffé à l'aide d'au moins une lampe à décharge gazeuse pendant une durée inférieure à une seconde en vue de relier hermétiquement le composant avec le matériau transparent à la lumière.

2. Procédé selon la revendication 1, le matériau anorganique transparent à la lumière étant un verre de silicate.

3. Procédé selon la revendication 1, le moyen anorganique absorbant la lumière étant une brasure de verre, une brasure en un alliage métallique ou une couche métallique.

4. Procédé selon la revendication 1, le composant contenant au moins un capteur, un afficheur, un semiconducteur pour la photovoltaïque, la microélectronique.

5. Procédé selon la revendication 1, la température moyenne du composant augmentant de moins de 80 degrés Celsius par le processus d'encapsulation.

6. Procédé selon la revendication 1, la lampe à décharge gazeuse fonctionnant en tant que flash ou avec une puissance continue.

7. Dispositif (100), configuré pour encapsuler un composant (110) conformément à un procédé selon les revendications précédentes en utilisant un matériau anorganique transparent à la lumière (130), en utilisant un moyen anorganique absorbant la lumière (140), **caractérisé en ce qu'**au moins une lampe à décharge gazeuse (150) est utilisée pour chauffer le moyen pour une liaison hermétique du composant avec matériau transparent à la lumière et **en ce qu'**un masque (170) est inséré entre le matériau transparent à la lumière et l'au moins une lampe à décharge gazeuse en vue de limiter l'incidence de la lumière (160) sur les zones du composant à relier au matériau transparent à la lumière.

8. Dispositif (100) pour encapsuler un composant (110) selon la revendication 7, **caractérisé en ce que** la lampe à décharge gazeuse (150) est configurée pour le fonctionnement en flash et/ou pour le fonctionnement continu.

9. Dispositif selon la revendication 7 ou 8, le masque se composant d'un matériau porteur transparent pour la lumière de la lampe à décharge gazeuse, sur lequel est appliquée une couche (180) réfléchissant la lumière comprenant des ouvertures (190).

10. Dispositif selon la revendication 9, le masque (170) étant utilisé pour presser le matériau transparent à la lumière (130) sur le composant (110) pendant le processus d'encapsulation.
